# EUROPEAN PATENT SPECIFICATION

(11) **EP 3 958 587 B1**
(45) Date of publication and mention of the grant of the patent: **16.09.2026**
(21) Application number: 21159186.2
(22) Date of filing: 25.02.2021
(51) Int. Cl.: H04R 1/08, H04R 1/32, H04R 1/22, H04R 17/02, H04R 1/24, H04R 17/10, H10N 30/30

(54) **DIRECTIONAL ACOUSTIC SENSOR**
AKUSTISCHER SENSOR MIT RICHTCHARAKTERISTIK
CAPTEUR ACOUSTIQUE DIRECTIONNEL

(30) Priority: 19.08.2020 KR 20200104154
(43) Date of publication of application: 23.02.2022
(73) Proprietor: Samsung Electronics Co., Ltd., Suwon-si, Gyeonggi-do 16677 (KR)
(72) Inventor: KANG, Sungchan, 16678, Gyeonggi-do, (KR); KIM, Cheheung, 16678, Gyeonggi-do, (KR); YOON, Yongseop, 16678, Gyeonggi-do, (KR); HONG, Hyeokki, 16678, Gyeonggi-do, (KR)
(74) Representative: Elkington and Fife LLP

(56) References cited:
- US-A1- 2018 131 347
- US-A1- 2019 072 635
- BENECKE W ET AL: "A FREQUENCY-SELECTIVE, PIEZORESISTIVE SILICON VIBRATION SENSOR", TRANSDUCERS'85 INTERNATIONAL CONFERENCE ON SOLID-STATE SENSORS AND ACTUATORS DIGEST OF TECHNICAL PAPERS,, 1 January 1985 (1985-01-01), pages 105 - 108, XP001420595

## Description

### FIELD OF THE INVENTION

Example embodiments of the present disclosure relate to a directional acoustic sensor.

### BACKGROUND OF THE INVENTION

The usability of acoustic sensors that are mounted on household appliances, video display devices, virtual reality devices, augmented reality devices, artificial intelligence speakers, and the like to detect the direction of sound and recognize voices is increasing. Recently, a directional acoustic sensor that detects an acoustic signal by converting a mechanical motion caused by a pressure difference into an electrical signal has been developed.

US 2018/0131347 discloses a system including a plurality of multi resonators. Individual resonators within each of the multi resonators have the same center frequency, while each multi resonator has a different center frequency.

### SUMMARY OF THE INVENTION

The invention is defined by the appended claims.

Example embodiments provide a directional acoustic sensor. By way of example, embodiments relate to a resonator, which is a component of a directional microphone, and may be used in apparatus (e.g.TV, AI speaker, etc.) requiring a voice interface. Embodiments may therefore be integrated in or with household appliances (air conditioners, air cleaners, etc.) for example.

Additional aspects will be set forth in part in the description which follows and, in part, will be apparent from the description, or may be learned by practice of the example embodiments of the disclosure.

Proposed embodiments may be realized with reference to a window of which an outer frame is thick and a glass part is thin. Since the resonant frequency of the resonator may be dominant in the outer frame portion, the length of the resonator may not change. Instead, the mass of the resonator may decrease as the thickness of the middle portion becomes thinner. According to a proposed resonator shape, only the mass may be reduced without changing its length and width. Therefore, since there is no change in the area under pressure, there may be no decrease in sensitivity. Also, since the mass is reduced, low-Q may be achieved.

The driving unit may be made of single crystal silicon, and the resonant frequency of the cantilever may be determined by the thickness and length of the driving unit. The sensor unit may be configured by depositing a piezoelectric material on the single crystal silicon. In the sensor unit, electric charges may be generated in proportion to the stress caused by the vibration displacement of the driving unit, and the generated electric charges may be detected by a circuit unit.

Based on the window shape, embodiments may be implemented in a form that reduces the thickness only in the middle of it. The resonant frequency of the resonator may be determined by the characteristics of the outer part frame, so there is no change in the width or length of the resonator. Therefore, there may be no reduction in sensitivity because there can be no change in the area of the part under pressure. Since the mass decreases as the thickness of the central portion of the resonator decreases, a resonator with a low-Q factor may be implemented.

Thus, there may be proposed a shape that reduces mass of a resonator while maintaining a resonant frequency without changing an area of the resonator. The mass may be reduced by reducing a thickness of a remaining part except an outer part. The mass may be reduced by reducing a thickness of a part of the resonator in a regular shape. The mass may be reduced by forming a hole with a size smaller than a wavelength of the audible frequency.

Each resonator of the plurality of resonators may have a same resonant frequency as a resonator that has a same length and has a frame thickness that is equal to a base thickness.

The frame may be integrally formed with the base.

Each of the base and the frame may include silicon.

The frame may be provided on an edge of the base along a width direction.

Each resonator of the plurality of resonators may have a resonant frequency that is different from other resonators of the plurality of resonators.

According to an aspect of an example embodiment, an acoustic sensor may include a support; and a plurality of resonators provided on the support, and extending in a length direction. Each resonator of the plurality of resonators may include a base and a groove pattern formed in the base to a certain depth.

Each of the plurality of resonators may have a same resonant frequency as a resonator that has a same length and does not have a groove pattern formed in a base thereof.

The groove pattern may be formed in a regular shape.

Each resonator of the plurality of resonators may have a resonant frequency that is different from resonant frequencies of other resonators of the plurality of resonators.

According to an aspect of an example embodiment, an electronic apparatus may include an acoustic sensor. The acoustic sensor may include a support; and a plurality of resonators provided on the support, and extending in a length direction. Each resonator of the plurality of resonators may include a base and a groove pattern formed in the base to a certain depth.

According to an aspect of an example embodiment, an acoustic sensor may include a support; and a plurality of resonators provided on the support, and extending in a length direction. Each of the plurality of resonators comprises a base and a groove pattern formed in the base and extending through the base in a thickness direction.

Each resonator of the plurality of resonators may have a same resonant frequency as a resonator that has a same length and that does not have a groove pattern formed in a base thereof.

The groove pattern may be formed in a regular shape.

According to an aspect of an example embodiment, an electronic apparatus may include an acoustic sensor. The acoustic sensor may include a support; and a plurality of resonators provided on the support, and extending in a length direction. Each resonator of the plurality of resonators may include a base and a groove pattern formed in the base and extending through the base in a thickness direction.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a perspective view of a general directional acoustic sensor;
FIG. 2 is an enlarged view of a portion A of FIG. 1;
FIG. 3 is a cross-sectional view taken along line III-III' of FIG. 2;
FIG. 4 illustrates an example of measurement results with regard to directivity characteristics of the directional acoustic sensor of FIG. 1;
FIG. 5 is a graph of measurement results with regard to frequency response characteristics of the directional acoustic sensor of FIG. 1;
FIG. 6A is a cross-sectional view of a resonator of a general directional acoustic sensor;
FIG. 6B is a graph of a relative ratio "A1" of inertia moment according to a change in the thickness of a resonator of FIG. 6A and a relative ratio "B1" of the length of the resonator to maintain resonance frequency constant;
FIG. 7 is a perspective view of a directional acoustic sensor according to an example embodiment;
FIG. 8 is an enlarged view of a portion B of FIG. 7;
FIG. 9 is a cross-sectional view taken along line IX-IX' of FIG. 8;
FIG. 10A is a cross-sectional view of the resonator of a directional acoustic sensor according to an example embodiment;
FIG. 10B is a graph of a relative ratio "A2" of inertia moment according to a change in the thickness of the resonator of FIG. 10A and a length relative ratio "B2" of the resonator to maintain resonance frequency constant;
FIG. 11 is a graph of a simulation result of a bandwidth change of the resonator according to a change in the sectional area of the resonator according to an example embodiment;
FIG. 12 is a graph of a simulation result by comparing a bandwidth of the resonator according to the related art with a bandwidth of the resonator according to an example embodiment;
FIG. 13A is a graph of a simulation result of measurement of the frequency response characteristics of the general directional acoustic sensor;
FIG. 13B is a graph of a simulation result of measurement of the frequency response characteristics of the general acoustic sensor;
FIG. 13C is a graph of a simulation result of measurement of the frequency response characteristics of the directional acoustic sensor according to an example embodiment;
FIG. 14A is a graph of a result of measurement through an actual experiment of the frequency response characteristics of the general directional acoustic sensor;
FIG. 14B is a graph of a result of measurement through an actual experiment of the frequency response characteristics of the directional acoustic sensor according to an example embodiment;
FIG. 15A is a graph of a simulation result of measurement of the frequency response characteristics of the general directional acoustic sensor;
FIG. 15B is a graph of a simulation result of measurement of the frequency response characteristics of the directional acoustic sensor according to an example embodiment;
FIG. 16 is a perspective view of a resonator of a directional acoustic sensor according to another example embodiment;
FIG. 17 is a perspective view of a resonator of a directional acoustic sensor according to another example embodiment;
FIG. 18 is a perspective view of a resonator of a directional acoustic sensor according to another example embodiment;
FIG. 19 is a perspective view of a resonator of a directional acoustic sensor according to another example embodiment; and
FIG. 20 is a perspective view of an electronic apparatus according to an example embodiment.

### DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The thickness or size of each layer illustrated in the drawings may be exaggerated for convenience of explanation and clarity. The example embodiments described below are merely examples, and various modifications may be made from the example embodiments.

When a constituent element is described as being provided, disposed, and the like, "above," "on," "below," "under," "on an upper side of," "on a lower side of," "on a right side of," "on a left side of," and the like, another constituent element, the constituent element may directly contact the other constituent element, or another element may be provided between the constituent element and the other constituent element. An expression used in a singular form in the specification also includes the expression in its plural form unless the context clearly specifies otherwise. When a part is described as "including" a certain constituent element, unless specified otherwise, the part may include another constituent element.

The use of the terms "a," "an," "the," and similar referents, in the context of describing the disclosure are to be construed to cover both the singular and the plural forms of the terms that the referents modify. Also, the steps of all methods described herein may be performed in any suitable order unless otherwise indicated herein or the context clearly specifies otherwise. The disclosure is not limited to the described order of the steps.

Terms such as "~ portion," "~ unit," "~ module," and "~ block" stated in the specification may signify a unit to process at least one function or operation, and the unit may be embodied by hardware, software, or a combination of hardware and software.

The connecting lines, or connectors, shown in the various figures represent functional relationships and/or physical or logical couplings between the various elements. It should be noted that many alternative or additional functional relationships, physical connections, or logical connections may be present in a device in practice.

The use of any and all examples, or language (e.g., "such as") provided herein, is intended merely to better describe the example embodiments of the disclosure and does not pose a limitation on the scope of the disclosure unless otherwise claimed.

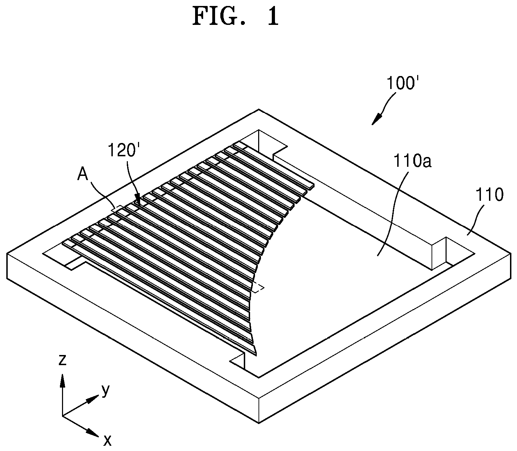

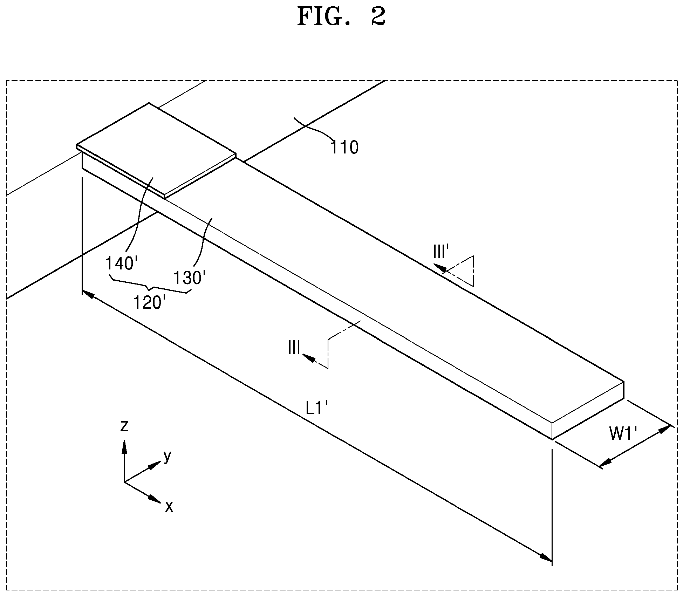

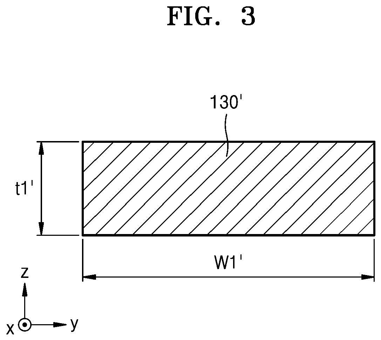

FIG. 1 is a perspective view of a general directional acoustic sensor 100'. FIG. 2 is an enlarged view of a portion A of FIG. 1. FIG. 3 is a cross-sectional view taken along line III-III' of FIG. 2.

Referring to FIGS. 1, 2, and 3, the general directional acoustic sensor 100' may include a support 110 and a plurality of resonators 120' provided on the support 110. A cavity 110A is formed in the support 110. The resonators 120' may be provided in a certain shape on the cavity 110A of the support 110.

Each of the resonators 120' may form a cantilever beam having a first end portion fixed to the support 110, and a second end portion configured to move freely. Each of the resonators 120' may include an actuating portion 130' configured to move in response to an input acoustic signal, and a sensing portion 140' configured to detect a motion of the actuating portion 130'. The actuating portion 130' may extend from the support 110 toward the cavity 110A in a length direction (an x-axis direction in FIG. 1) of the resonators 120'. The sensing portion 140' may be provided on a surface of the actuating portion 130' to detect a motion of the actuating portion 130'. The sensing portion 140' may include a piezoelectric device that is configured to generate electric energy based on deformation of a piezoelectric body.

The actuating portion 130' may have a length L1', a width W1', and a thickness t1'. An area of a portion of the actuating portion 130' that is configured to receive pressure based on an input acoustic signal may be L1' × W1'.

The respective resonators 120' may be configured to have different resonant frequencies. Accordingly, the respective resonators 120' may have different dimensions. For example, the respective resonators 120' may have different lengths, widths, and/or thicknesses. FIG. 1 illustrates a case in which the respective resonators 120' have different lengths.

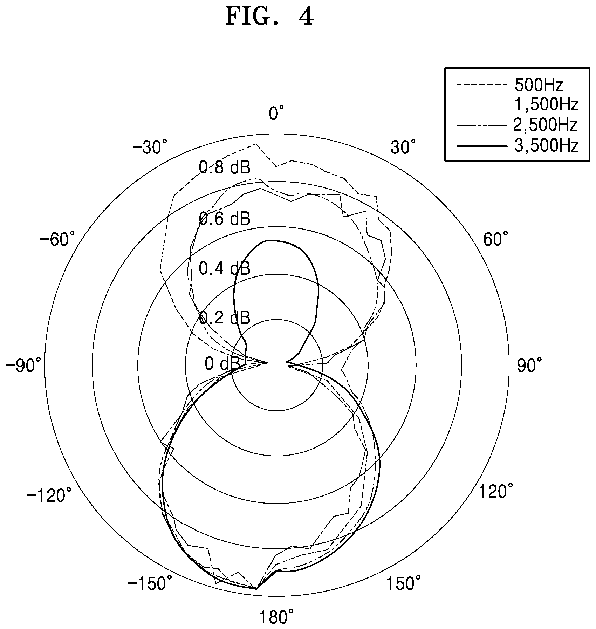

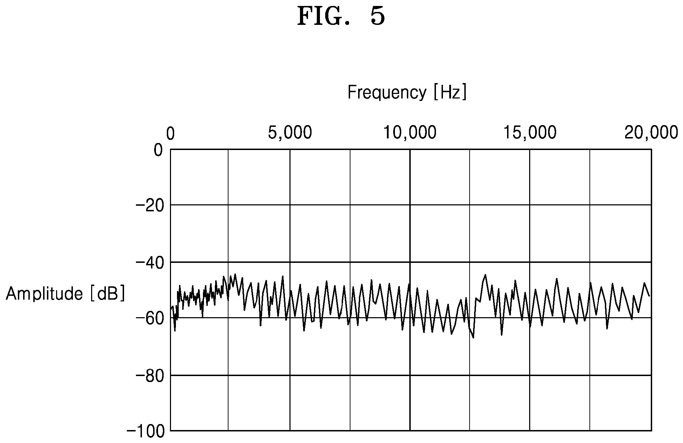

FIG. 4 illustrates an example of measurement results with regard to directivity characteristics of the directional acoustic sensor 100' of FIG. 1. As shown in FIG. 4, the general directional acoustic sensor 100' exhibits bi-directionality, that is, directionality in a z-axis direction of a 0° direction and a 180° direction. FIG. 5 is a graph of measurement results with regard to frequency response characteristics of the general directional acoustic sensor 100' of FIG. 1.

In the general directional acoustic sensor 100' of FIG. 1, as a method to reduce the size thereof, the number of the resonators 120' are reduced. In this case, the vertical width of ripples is increased in the frequency response characteristics shown in FIG. 5 so that flatness characteristics deteriorate. Accordingly, the sound quality of the general directional acoustic sensor 100' may deteriorate.

In order to implement a wide frequency band by using a limited number of resonators and improve the flatness characteristics, each resonator has a wide bandwidth, and accordingly, the quality factor of a resonator should be small.

The quality factor (Q) of a resonator may be expressed by the following equation [Equation 1]. $Q = \left(m\times f\right) / c$

In Equation 1, "m" denotes an effective mass, "f" denotes a resonant frequency, and "c" denotes a damping coefficient.

Referring to Equation 1, in order to reduce the quality factor while maintaining a constant resonant frequency of a resonator, the mass of the resonator should be reduced.

In the general directional acoustic sensor 100' of FIG. 1, when the thickness of each of the actuating portions 130' is reduced to decrease the mass of each of the resonators 120', the length of each of the resonators 120' should be reduced in order to maintain a constant resonant frequency, as described below. However, in this case, as the area of a portion configured to receive a pressure by an input acoustic signal decreases, sensitivity may deteriorate. Accordingly, in the general directional acoustic sensor 100' of FIG. 1, when the quality factor is reduced by decreasing the thickness of each of the resonators 120', the flatness characteristics may be improved, but the sensitivity may deteriorate.

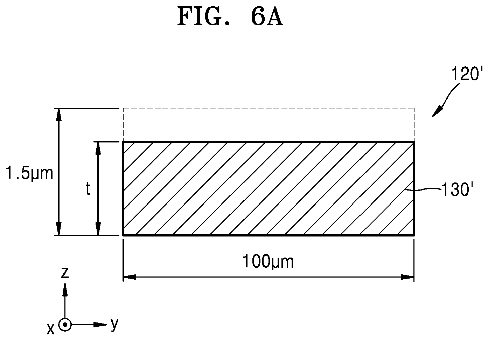

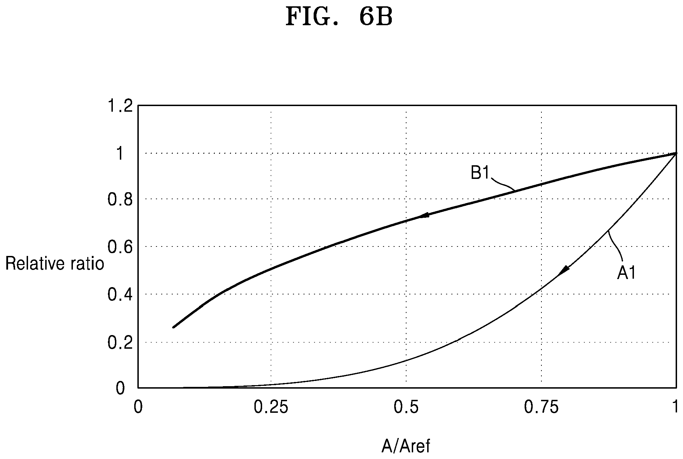

FIG. 6A is a cross-sectional view of the actuating portion 130' of the resonator 120' of FIG. 2. FIG. 6B is a graph of a relative ratio "A1" of an inertia moment measured by gradually decreasing a thickness t of the resonator 120' of FIG. 6A from 1.5 µm, and a relative ratio "B1" of the length of a resonator to maintain a constant resonant frequency. The width of the resonator 120' is 100 µm.

In FIG. 6B, "A/A_{ref}" denotes a relative ratio of a sectional area of the resonator 120', and "A_{ref}" denotes a sectional area of the resonator 120' when the thickness of the resonator 120' is 1.5 µm. "A1" denotes a curve indicating a relative ratio (I/I_{ref}) of an inertia moment, and "I_{ref}" denotes the inertia moment of the resonator 120' when the thickness of the resonator 120' is 1.5 µm. "B1" denotes a relative ratio (L/L_{ref}) of the length of the resonator to maintain the constant resonant frequency, and "L_{ref}" denotes the length of the resonator 120' when the thickness of the resonator 120' is 1.5 µm.

Referring to FIG. 6B, as the thickness of the resonator 120' shown in FIG. 6A is gradually reduced from 1.5 µm so that the sectional area of the resonator 120' decreases, the inertia moment of the resonator 120' may also be reduced. In this case, the length of the resonator 120' should be reduced to reduce the thickness of the resonator 120' while maintaining the constant resonant frequency of the resonator 120'.

As such, in the general directional acoustic sensor 100' of FIG. 1, when the mass of the resonator 120' is reduced by decreasing the thickness of the resonator 120', the length of the resonator 120' should be reduced to maintain the constant resonant frequency. Accordingly, the area of a portion configured to receive a pressure by an input acoustic signal decreases which causes the sensitivity of the general directional acoustic sensor 100' to deteriorate.

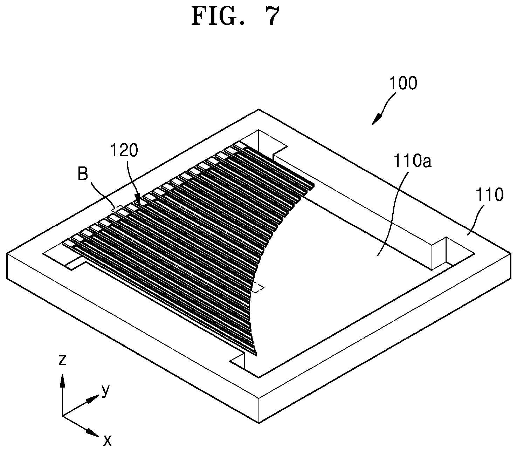

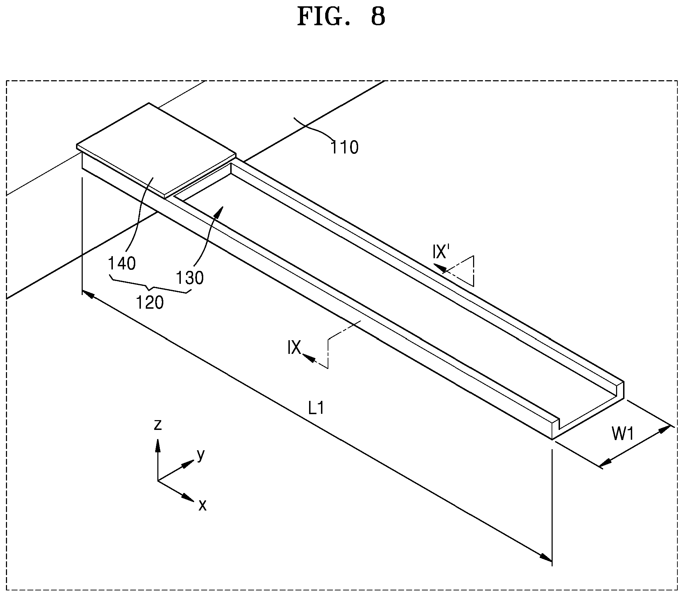

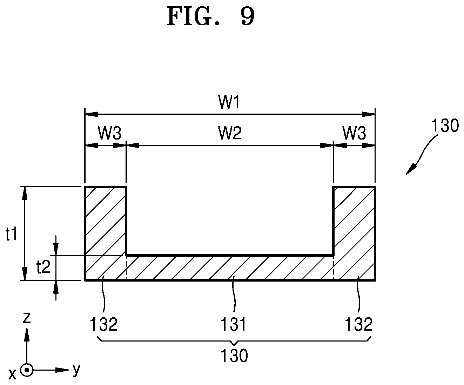

FIG. 7 is a perspective view of a directional acoustic sensor 100 according to an example embodiment. FIG. 8 is an enlarged view of a portion B of FIG. 7, and FIG. 9 is a cross-sectional view taken along line IX-IX' of FIG. 8.

Referring to FIGS. 7 to 9, the directional acoustic sensor 100 may include a support 110, and a plurality of resonators 120 provided on the support 110. A cavity 110A is formed in the support 110. As an example, a silicon substrate may be used as the support 110, but the disclosure is not limited thereto. The resonators 120 may be provided on the cavity 110A of the support 110. The resonators 120 may be provided on a plane without overlapping each other.

Each of the resonators 120 may form a cantilever beam having a first end portion fixed to the support 110, and a second end portion configured to freely move. FIG. 7 illustrates an example embodiment in which the resonators 120 are configured to move vertically in the z-axis direction.

Each of the resonators 120 may have a length L1 and a width W1. An area of a portion configured to receive a pressure by an input acoustic signal may be L1 × W1.

For example, when the resonator 120 of FIG. 8 has the same resonant frequency as the resonator 120' of FIG. 2, the length L1 and the width W1 of the resonator 120 of FIG. 8 may be the same as the length L1' and the width W1' of the resonator 120' of FIG. 2. In this case, the resonator 120 of FIG. 8 and the resonator 120' of FIG. 2 may have the same area of a portion configured to receive a pressure by an input acoustic signal.

Each of the resonators 120 may include an actuating portion 130 configured to move in response to an input acoustic signal, and a sensing portion 140 configured to detect a motion of the actuating portion 130. The actuating portion 130 may extend from the support 110 toward the cavity 110A in a length direction (an x-axis direction in FIG. 7) of the resonators 120. A first end portion of the actuating portion 130 is fixed to the support 110. The actuating portion 130 may be formed integrally with the support 110. In this case, the actuating portion 130 may include, for example, silicon. However, the disclosure is not limited thereto, and the actuating portion 130 might not be formed integrally with the support 110.

The actuating portion 130 of each of the resonators 120 may include a base 131, and a frame 132 provided at both sides of the base 131. The frame 132 may be continuously provided parallel to the length direction (the x-axis direction in FIG. 8) of the resonator 120. In detail, the frame 132 may be continuously provided along both side edges of the base 131.

The frame 132 may extend along an entire length of the base 131 in the length direction. For example, as shown in FIG. 8, the frame 132 extends along the entire length of the base 131 in the length direction. Alternatively, the frame 132 may extend along substantially an entire length of the base 131 in the length direction. For example, the frame 132 may extend along 75%, 80%, 85%, 90%, 95%, 97%, etc. of the base 131. Because the base 131 is thinner than the frame 132, the resonator 120 includes less mass than as compared to a comparative resonator having a same length as the resonator 120 and a constant thickness. By extending along the entire length, or substantially the entire length, of the base 131, the frame 132 may render the resonator 120 as having a similar, or same, resonant frequency as the comparative resonator. In this way, the resonator 120 may have an improved bandwidth, a reduced quality factor, improved flatness characteristics, and improved sound quality as compared to the comparative resonator.

The base 131 may have a width W2, and the frame 132 may have a width W3. For example, the width W3 of the frame 132 may be less than the width W2 of the base 131, but the disclosure is not limited thereto. The frame 132 may have a thickness t1, and the base 131 may have a thickness t2 that is less than the thickness t1 of the frame 132.

For example, when the resonator 120 of FIG. 8 has the same resonant frequency as the resonator 120' of FIG. 2, the thickness t1 of the frame 132 illustrated in FIG. 8 may be the same as the thickness t1' of the actuating portion 130' illustrated in FIG. 2.

When the length L1 and the width W1 of the resonator 120 of FIG. 8 are the same as the length L1' and the width W1' of the resonator 120' of FIG. 2, and the thickness t1 of the frame 132 illustrated in FIG. 8 is the same as the thickness t1' of the actuating portion 130' illustrated in FIG. 2, the resonator 120 of FIG. 8 may have the same resonant frequency as the resonator 120' of FIG. 2.

The sensing portion 140 may be provided on a surface of the actuating portion 130, and may be configured to detect motion of the actuating portion 130. The sensing portion 140 may include a piezoelectric device that is configured to generate electric energy based on deformation of a piezoelectric body. In this case, the sensing portion 140 may include two electrodes, and a piezoelectric layer provided between the two electrodes.

The respective resonators 120 may be configured to detect acoustic frequencies of different bands. In other words, the respective resonators 120 may have different resonant frequencies. In this case, the respective resonators 120 may have different dimensions. For example, the respective resonators 120 may have different lengths, widths, and/or thicknesses. FIG. 7 illustrates a case in which the respective resonators 120 have different lengths. The directional acoustic sensor 100 according to the example embodiment may have directionality such as, for example, bi-directionality in the z-axis direction, as similar to the general directional acoustic sensor 100' of FIG. 1.

In the directional acoustic sensor 100 according to the example embodiment, because the actuating portion 130 includes the frame 132, and the base 131 having the thickness t2 that is less than the thickness t1 of the frame 132, mass may be reduced as compared to the resonator 120' of FIG. 2 while maintaining the resonant frequency, as described below. Accordingly, as the quality factor of the resonator 120 is reduced, the bandwidth thereof may be increased, and thus the flatness characteristics and sound quality of the directional acoustic sensor 100 may be improved.

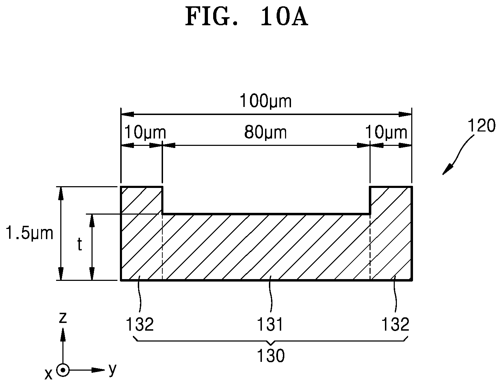

FIG. 10A is a cross-sectional view of the actuating portion 130, of FIG. 8, in which the base 131 has a thickness t. The resonator 120 may include silicon. In FIG. 10A, the width W2 of the base 131 and the width W3 of the frame 132 are respectively 80 µm and 10 µm, and the thickness t1 of the frame 132 is 1.5 µm.

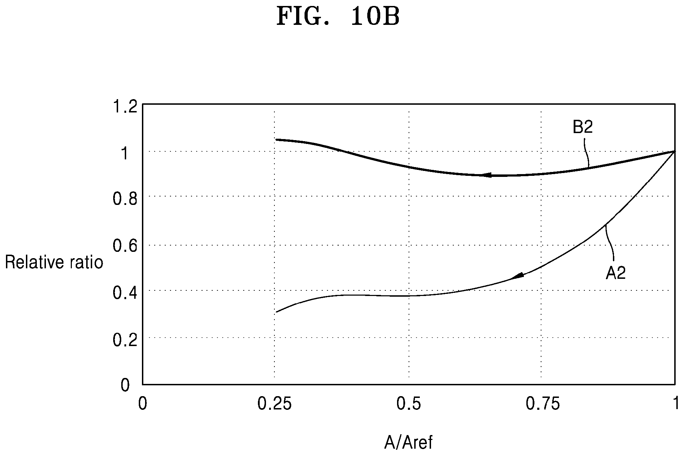

FIG. 10B is a graph of a relative ratio "A2" of inertia moment measured by gradually decreasing a thickness t of the resonator 120 of FIG. 10A from 1.5 µm, and a relative ratio "B2" of the length of the resonator to maintain resonance frequency constant.

In FIG. 10B, "A/A_{ref}" denotes a relative ratio of a sectional area of the resonator 120, and "A_{ref}" denotes a sectional area of the resonator 120 when the thickness t of the base 131 is 1.5 µm. "A2" is a curve indicating a relative ratio I/I_{ref} of an inertia moment, and "I_{ref}" denotes the inertia moment of the resonator 120' when the thickness t of the base 131 is 1.5 µm. "B1" is a curve indicating a relative ratio L/L_{ref} of the length of the resonator to maintain the resonance frequency constant, and "L_{ref}" denotes the length of the resonator 120 when the thickness t of the base 131 is 1.5 µm.

Referring to FIG. 10B, as the thickness t of the base 131 of the resonator 120 illustrated in FIG. 10A is gradually reduced from 1.5 µm so that the sectional area of the resonator 120 decreases, the inertia moment of the resonator 120 is initially gradually decreased and becomes constant later. Accordingly, in this case, the resonant frequency of the resonator 120 is maintained to be constant without significantly decreasing the length of the resonator 120.

As such, in the resonator 120 of FIG. 10A, the mass of the resonator 120 may be reduced without changing the resonant frequency by reducing the thickness t of the base 131 in the frame 132, and without changing the length of the resonators 120.

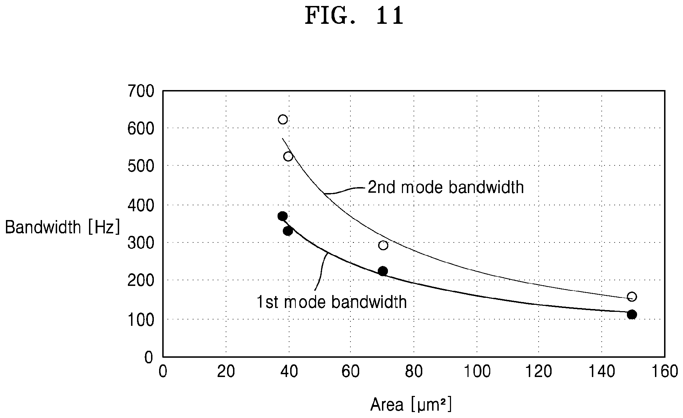

FIG. 11 is a graph of a simulation result of a bandwidth change of the resonator 120 according to a change in the sectional area of the resonator 120 according to an example embodiment. FIG. 11 illustrates a result of measurement while changing the thickness t of the base 131 in the resonator 120 of FIG. 10A. The resonator 120 in which the thickness t of the base 131 is 1.5 µm may correspond to the general resonator 120' of FIG.2 having a 1.5 µm thickness and a 100 µm width.

Referring to FIG. 11, when the sectional area of the resonator 120 according to an example embodiment is reduced by about half as compared with the sectional area of the general resonator 120' of FIG. 2, and thus the mass of the resonator 120 according to an example embodiment is reduced by about twice compared with the mass of the general resonator 120' of FIG. 2, the bandwidth of the resonator 120 according to an example embodiment is increased by about twice as compared with the bandwidth of the general resonator 120' of FIG. 2.

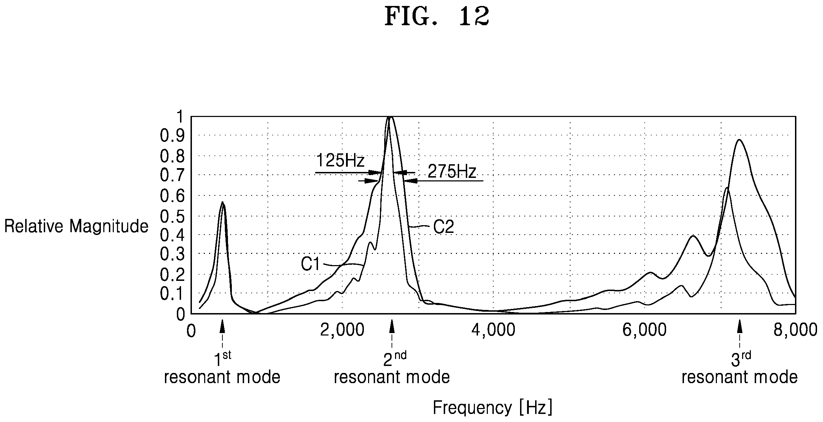

FIG. 12 is a graph of a simulation result by comparing the bandwidth of the general resonator 120' of FIG. 2 with the bandwidth of the resonator 120 according to an example embodiment. The general resonator 120' of FIG. 2 corresponds to the resonator 120 in which the thickness t of the base 131 is 1.5 µm in FIG. 10A, and the resonator 120 according to an example embodiment corresponds to a case in which the thickness t of the base 131 is 0.5 µm in FIG. 10A.

In FIG. 12, "C1" denotes the frequency response characteristics of the general resonator 120' of FIG. 2, and "C2" denotes the frequency response characteristics of the resonator 120 according to an example embodiment.

Referring to FIG. 12, with respect to the 2^{nd} resonant mode, the bandwidth of the general resonator 120' of FIG. 2 is measured to be about 125 Hz, and the bandwidth of the resonator 120 according to an example embodiment is measured to be about 275 Hz. Accordingly, the bandwidth of the resonator 120 according to an example embodiment is increased by about twice or more as compared with the bandwidth of the general resonator 120' of FIG. 2. In this way, the quality factor of the resonator 120 according to an example embodiment is reduced by about twice or more as compared with the quality factor of the resonator 120' of FIG. 2 without a change in the resonant frequency.

As such, because the resonator 120 according to an example embodiment is configured such that the base 131 has the thickness t2 less than the thickness t1 of the frame 132 is provided between the frames 132, the mass of the resonator 120 may be reduced while maintaining the resonant frequency. Accordingly, in the resonator 120 according to an example embodiment, the quality factor may be reduced and the bandwidth may be increased as compared with the general resonator 120' of FIG. 2.

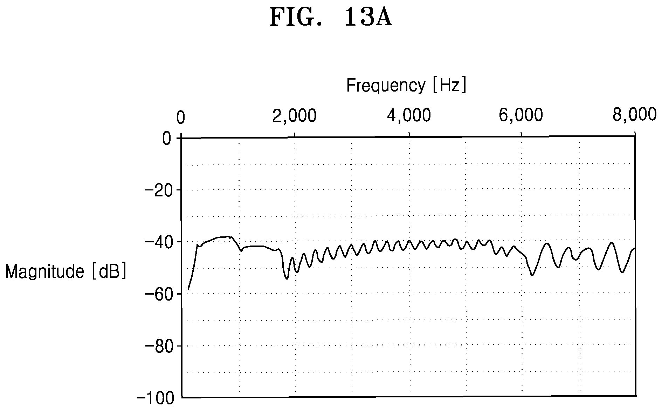

FIG. 13A is a graph of a simulation result of measurement of the frequency response characteristics of the general directional acoustic sensor 100'. The general directional acoustic sensor 100', which is the general directional acoustic sensor 100' of FIG. 1, may include thirty two (32) resonators 120'. Each of the resonators 120' may include silicon, and has a 1.5 µm thickness and a 100 µm width.

Referring to FIG. 13A, in the frequency range of 300 Hz to 7000 Hz, the sensitivity is measured to be about 43 dB, and the flatness is measured to be about 3.3 dB. The flatness refers to the size of the vertical width of ripples in a frequency response characteristics curve.

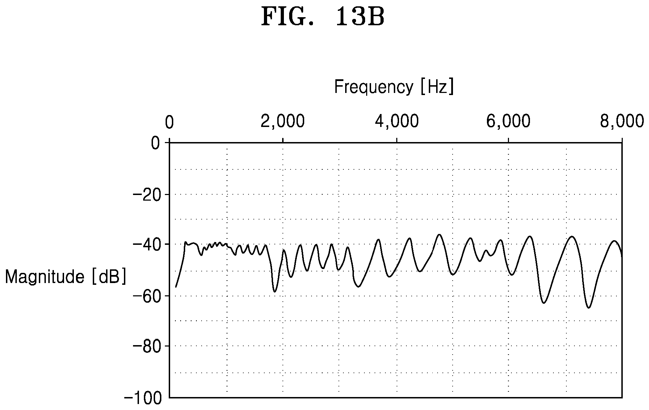

FIG. 13B is a graph of a simulation result of measurement of the frequency response characteristics of the general directional acoustic sensor 100'. The general directional acoustic sensor 100' includes sixteen (16) resonators 120', but is otherwise identical to the directional acoustic sensor 100' used in FIG. 13A

Referring to FIG. 13B, in the frequency range of 300 Hz to 7000 Hz, the sensitivity is measured to be about 45 dB, and the flatness is measured to be about 5.5 dB. In a comparison between FIG. 13A and FIG. 13B, the flatness deteriorates by reducing the number of the resonators 120' in the general directional acoustic sensor 100'.

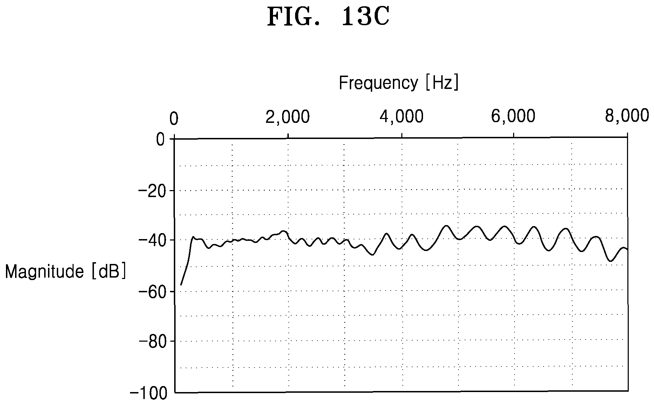

FIG. 13C is a graph of a simulation result of measurement of the frequency response characteristics of the directional acoustic sensor 100 according to an example embodiment. The directional acoustic sensor 100, which is the directional acoustic sensor 100 illustrated in FIG. 7, may include sixteen (16) resonators 120. Each of the resonators 120 may include silicon. The thickness t and the width of the base 131 are respectively 0.5 µm and 80 µm, and the thickness and the width of the frame 132 are respectively 1.5 µm and 10 µm.

Referring to FIG. 13C, in the frequency range of 300 Hz to 7000 Hz, the sensitivity is measured to be about 40 dB, and the flatness is measured to be about 2.4 dB. In a comparison between FIG. 13B and FIG. 13C, when the numbers of the resonators 120' and120 are the same, the directional acoustic sensor 100 according to an example embodiment has significantly improved flatness with similar sensitivity, as compared with the general directional acoustic sensor 100'. Further, referring to FIGS. 13A and 13C, referring to the directional acoustic sensor 100 according to an example embodiment, even when the number of the resonators 120 is reduced by half, the flatness is improved while the sensitivity is similar, as compared with the general directional acoustic sensor 100'.

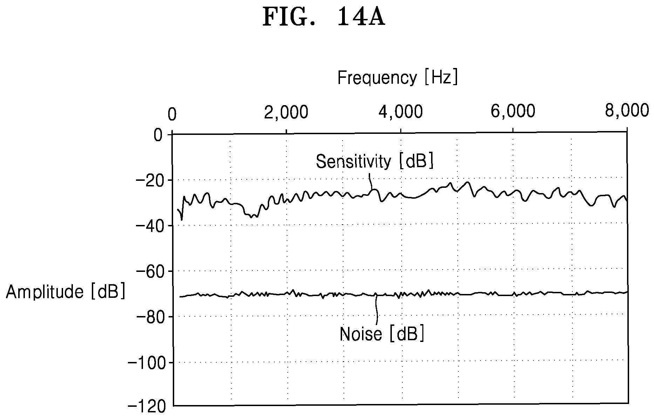

FIG. 14A is a graph of a result of measurement through an actual experiment of the frequency response characteristics of the general directional acoustic sensor 100'. The general directional acoustic sensor 100', which is the general directional acoustic sensor 100' of FIG. 1, may include thirty two (32) resonators 120'. Each of the resonators 120' may include silicon, and have a 1.5 µm thickness and a 100 µm width. Referring to FIG. 14A, in the frequency range of 300 Hz to 7000 Hz, the sensitivity is measured to be about 43.5 dB, and the flatness is measured to be about 6 dB.

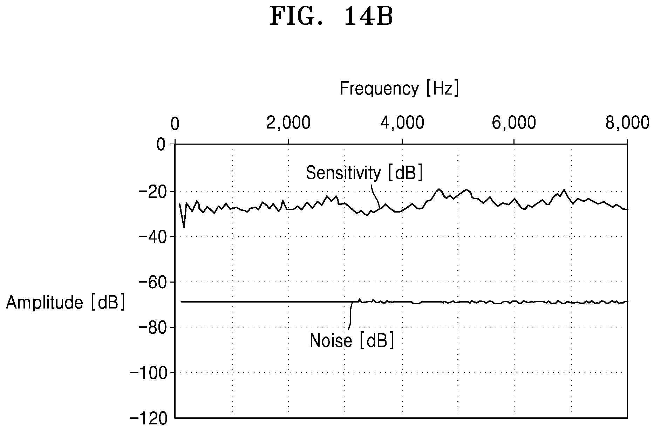

FIG. 14B is a graph of a result of measurement through an actual experiment of the frequency response characteristics of the directional acoustic sensor 100 according to an example embodiment. The directional acoustic sensor 100, which is the directional acoustic sensor 100 illustrated in FIG. 7, may include sixteen (16) resonators 120. Each of the resonators 120 may include silicon. The thickness t and the width of the base 131 are respectively 0.5 µm and 80 µm, and the thickness and the width of the frame 132 are respectively 1.5 µm and 10 µm. Referring to FIG. 14B, in the frequency range of 300 Hz to 7000 Hz, the sensitivity is measured to be about 43 dB, and the flatness is measured to be about 8 dB.

In a comparison between FIG. 14A and FIG. 14B, the general directional acoustic sensor 100' including thirty two (32) resonators 120' and the directional acoustic sensor 100 according to an example embodiment including the sixteen (16) resonators 120 have sensitivity and flatness similar to each other.

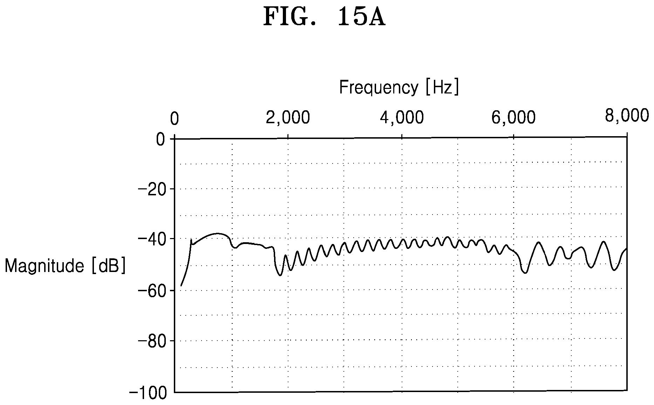

FIG. 15A is a graph of a simulation result of measurement of the frequency response characteristics of the general directional acoustic sensor 100', which is the same as the graph of FIG. 13A. The general directional acoustic sensor 100', which is the general directional acoustic sensor 100' of FIG. 1, may include thirty two (32) resonators 120'. Each of the resonators 120' may include silicon, and has a 1.5 µm thickness and a 100 µm width. Referring to FIG. 15A, in the frequency range of 300 Hz to 7000 Hz, the sensitivity is measured to be about 43 dB, and the flatness is measured to be about 3.3 dB.

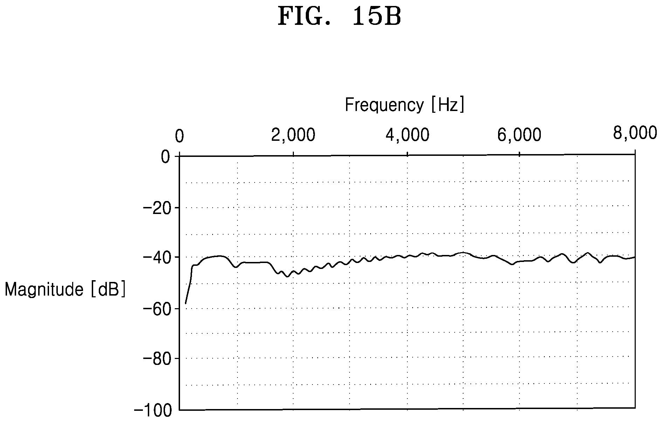

FIG. 15B is a graph of a simulation result of measurement of the frequency response characteristics of the directional acoustic sensor 100 according to an example embodiment. The directional acoustic sensor 100, which is the directional acoustic sensor 100 illustrated in FIG. 7, may include thirty two (32) resonators 120. Each of the resonators 120 may include silicon. The thickness t and the width of the base 131 are respectively 0.5 µm and 80 µm, and the thickness and the width of the frame 132 are respectively 1.5 µm and 10 µm. Referring to FIG. 15B, in the frequency range of 300 Hz to 7000 Hz, the sensitivity is measured to be about 41.5 dB, and the flatness is measured to be about 2.1 dB.

Referring to FIGS. 15A and 15B, when the numbers of the resonators 120' and 120 are identical to each other, the directional acoustic sensor 100 according to an example embodiment has similar sensitivity and improved flatness, as compared with the general directional acoustic sensor 100'.

As described above, in the directional acoustic sensor 100 according to an example embodiment, because each of the resonators 120 is configured such that the base 131 has the thickness t2 that is less than the thickness t1 of the frame 132, the mass of each of the resonators 120 may be reduced while maintaining a constant resonant frequency. Accordingly, the quality factor may be reduced and the bandwidth may be increased as compared with the resonators 120' of FIG. 2.

As such, in the directional acoustic sensor 100 according to an example embodiment, as each of the resonators 120 may have a wide bandwidth while maintaining the constant resonant frequency, the flatness characteristics may be improved. Accordingly, even when the number of the resonators 120 is reduced as compared with the general directional acoustic sensor 100', the sensitivity and the sound quality may be substantially maintained.

Accordingly, referring to the directional acoustic sensor 100 according to an example embodiment, because the number of the resonators 120 may be reduced while maintaining the sensitivity and flatness characteristics, as compared with the general directional acoustic sensor 100' of FIG. 1, price competitiveness may be improved. Further, referring to the directional acoustic sensor 100 according to an example embodiment, when the number of the resonators 120 is the same as that of the general directional acoustic sensor 100' of FIG. 1, the sound quality may be improved as compared with the general directional acoustic sensor 100' of FIG. 1 based on the improvement of the flatness characteristics.

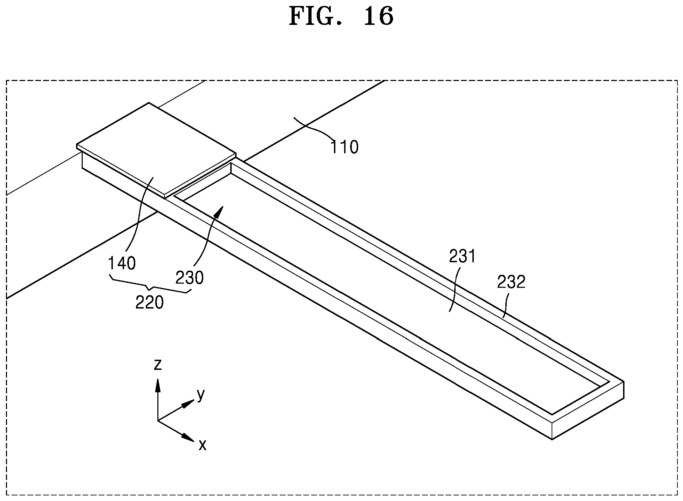

FIG. 16 is a perspective view of a resonator 200 of a directional acoustic sensor according to another example embodiment. Although a single resonator 220 is shown in FIG. 16, it should be understood that the directional acoustic sensor may include additional resonators, and that the respective resonators may have different resonant frequencies. In the following description, differences from the above-described embodiments are mainly described.

Referring to FIG. 16, the resonator 220 may include an actuating portion 230 configured to move in response to an input acoustic signal, and a sensing portion 140 configured to detect a motion of the actuating portion 230. The actuating portion 230 may extend from the support 110 in a length direction of the resonator 220.

The actuating portion 230 of the resonator 220 may include a base 231 and a frame 232 provided on the base 231. Because the base 231 is configured to have a thickness less than that of the frame 232, as described above, the mass of the resonator 220 may be reduced as compared with the resonators 120' of FIG. 2.

The frame 232 is provided along an edge of the base 231. In detail, the frame 232 may be provided at both side edges of the base 231 and an edge of a leading portion of the base 231. Each frame 232 provided at respective side edges of the base 231 may be continuously provided parallel to the length direction of the resonator 220.

The frame 232 may extend along an entire length of the base 231 in the length direction, and may extend along a width of the base 231 in the width direction. For example, as shown in FIG. 16, the frame 232 extends along the entire length of the base 231 in the length direction, and extends along the width of the base 231 in the width direction. Alternatively, the frame 232 may extend along substantially an entire length of the base 231 in the length direction. For example, the frame 232 may extend along 75%, 80%, 85%, 90%, 95%, 97%, etc. of the base 231. Because the base 231 is thinner than the frame 232, the resonator 220 includes less mass than as compared to a comparative resonator having a same length as the resonator 220 and a constant thickness. By extending along the entire length, or substantially the entire length, of the base 231, the frame 232 may render the resonator 220 as having a similar, or same, resonant frequency as the comparative resonator. In this way, the resonator 220 may have an improved bandwidth, a reduced quality factor, improved flatness characteristics, and improved sound quality as compared to the comparative resonator.

In the example embodiment, because the resonator 220 is configured such that the base 231 has a thickness less than that of the frame 232, the mass of the resonator 220 may be reduced while maintaining the constant resonant frequency, as compared with the above-described resonators 120' of FIG. 2. Accordingly, the quality factor of the resonators 220 may be reduced and the bandwidth may be increased.

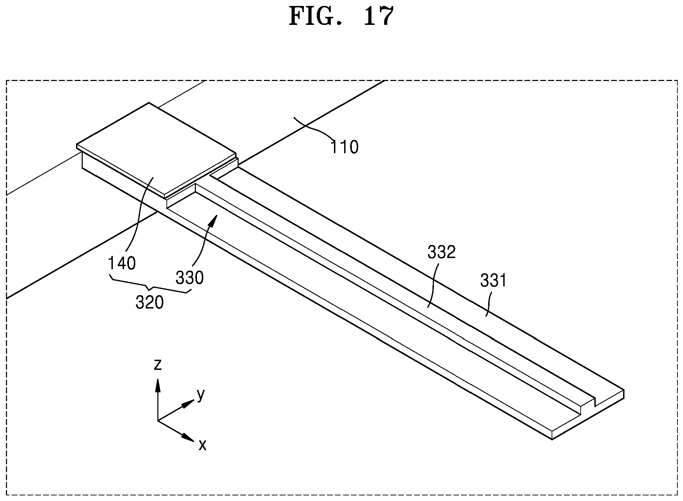

FIG. 17 is a perspective view of a resonator 320 of a directional acoustic sensor according to another example embodiment.

Referring to FIG. 17, an actuating portion 330 of the resonator 320 may include a base 331 and a frame 332 provided on the base 331. The base 331 may be configured to have a thickness less than that of the frame 332, as described above.

The frame 332 may be provided continuously inside the base 331 along a length direction of the resonator 320.For example, as shown in FIG. 17, the frame 332 is disposed inside the base 331 in a width direction (the y-axis direction shown in FIG. 17). That is, the frame 332 may be spaced apart from side edges of the base 331. For example, the frame 332 may be disposed at a center of the base 331 in the width direction, towards a center of the base 331 in the width direction, offset from the center of the base 331 in the width direction, and the like. Although FIG. 17 illustrates a single frame 332 as an example, the disclosure is not limited thereto, and a plurality of frames 332 may be provided on and inside the base 331.

The frame 132 may extend along an entire length of the base 331 in the length direction. For example, as shown in FIG. 17, the frame 332 extends along the entire length of the base 331 in the length direction. Alternatively, the frame 332 may extend along substantially an entire length of the base 331 in the length direction. For example, the frame 332 may extend along 75%, 80%, 85%, 90%, 95%, 97%, etc. of the base 331. Because the base 331 is thinner than the frame 332, the resonator 320 includes less mass than as compared to a comparative resonator having a same length as the resonator 320 and a constant thickness. By extending along the entire length, or substantially the entire length, of the base 331, the frame 332 may render the resonator 320 as having a similar, or same, resonant frequency as the comparative resonator. In this way, the resonator 320 may have an improved bandwidth, a reduced quality factor, improved flatness characteristics, and improved sound quality as compared to the comparative resonator.

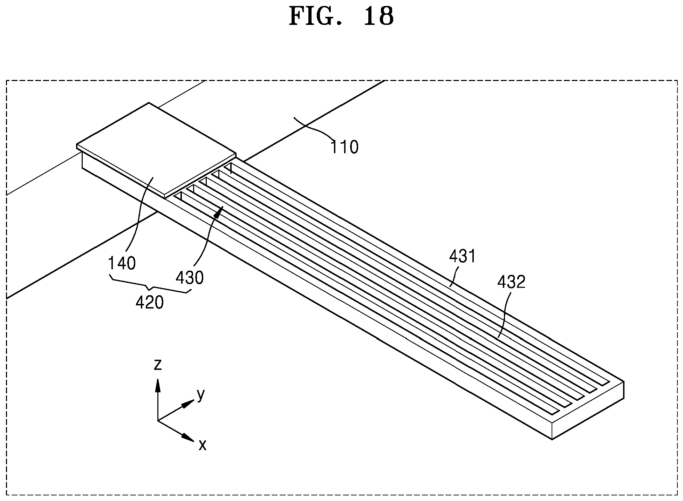

FIG. 18 is a perspective view of a resonator 420 of a directional acoustic sensor according to another example embodiment.

Referring to FIG. 18, an actuating portion 430 of the resonator 420 may include a base 431 and a groove pattern 432 formed in the base 131 to a certain depth. For example, the groove pattern 432 may be formed in the base 131 to a predetermined depth, such as 10%, 20%, 30%, 40%, 50%, 60%, 70%, 80%, 90%, 92%, 100%, and the like, of the depth of the base 431. Alternatively, the groove pattern 432 may be formed to extend through the base in the thickness direction (the z-axis direction of FIG. 18). The groove pattern 432 may be formed in the base 431 in a regular shape. As the groove pattern 432 is formed in the base 431 to a certain depth, the mass of the resonator 420 may be reduced, as compared with the resonators 120' of FIG. 2. The regular shape may refer to a constant or predetermined shape and pattern, and may include a similar space between individual grooves. The grooves may be circular, rectangular, square, oval, or other shapes.

The resonator 420 of FIG. 18 may have the same resonant frequency as a resonator in which the groove pattern 432 is not formed such as the resonators 120' of FIG. 2 applied to the general directional acoustic sensor 100' of FIG. 1.

In the example embodiment, because the resonator 420 includes the groove pattern 432 formed in the base 431 to a certain depth, the mass of the resonator 420 may be reduced while maintaining the constant resonant frequency. Accordingly, the quality factor may be reduced and the bandwidth may be increased as compared with the resonators 120' of FIG. 2.

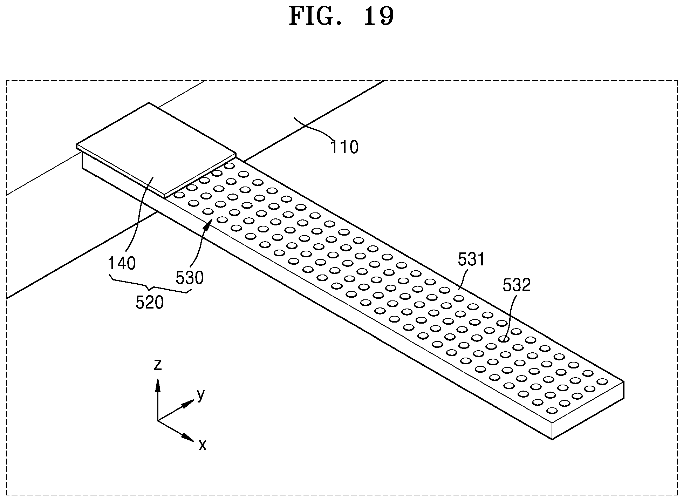

FIG. 19 is a perspective view of a resonator 520 of a directional acoustic sensor according to another example embodiment.

Referring to FIG. 19, an actuating portion 530 of the resonator 520 may include a base 531 and a plurality of through-holes 532 formed in the base 531. The through-holes 532 may be formed in the base 531 in a regular shape. The regular shape may refer to a constant or predetermined shape and pattern, and may include a similar space between individual through-holes. The through-holes may be circular, rectangular, square, oval, or other shapes.

The resonator 520 of FIG. 19 may have the same resonant frequency as a resonator in which the through-holes 532 are not formed such as the resonators 120' of FIG. 2 applied to the general directional acoustic sensor 100' of FIG. 1. Each of the through-holes 532 may be formed to include a size less than the wavelength of an audible frequency band.

In the example embodiment, because the resonator 520 includes the through-holes 532 formed in the base 531, and because each of the through-holes 532 may include a size less than the wavelength of an audible frequency band, the mass of the resonator 520 may be reduced while maintaining a constant resonant frequency. Accordingly, the quality factor may be reduced and the bandwidth may be increased as compared with the resonators 120' of FIG. 2.

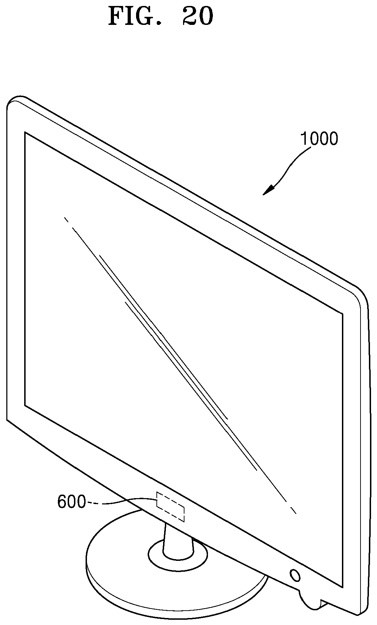

The above-described directional acoustic sensor may be applied to electronic apparatuses such as, for example, artificial intelligent (AI) speakers, televisions (TVs), and the like, to which voice interface technology is applied. FIG. 20 illustrates an example of a TV 1000 employing a directional acoustic sensor 600 configured to recognize a user's voice. Further, the above-described directional acoustic sensor may be applied to various electronic apparatuses including home appliances such as air conditioners, refrigerators, air purifiers, and the like.

In the above-described directional acoustic sensors according to the example embodiments, because each resonator has a wide bandwidth while maintaining a constant resonant frequency constant, the flatness characteristics may be improved. Accordingly, even when the number of resonators is reduced, the sensitivity and the sound quality may be substantially maintained , as compared with the general directional acoustic sensor. As such, referring to the directional acoustic sensor according to an example embodiment, because the number of resonators may be reduced while maintaining the sensitivity and flatness characteristics, as compared with a general directional acoustic sensor, price competitiveness may be improved. Further, referring to the directional acoustic sensor according to an example embodiment, when the number of resonators is the same as that of the existing directional acoustic sensor, the flatness characteristics is improved, and thus the sound quality may be improved.

It should be understood that the example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. An acoustic sensor (100) comprising:
a support (110); and
a plurality of resonators (120) provided on the support, and extending in a length direction (x), wherein each resonator of the plurality of resonators comprises a cantilever beam having a first end fixed to the support and a second end configured to move freely within a cavity of the support in response to an input acoustic signal in a first direction perpendicular to the length direction of the resonator, and comprising an actuating portion (130) and a sensing portion (140) configured to detect a motion of the actuating portion,
and **characterized in that** the actuating portion comprises:
a base (131); and
a frame (132) provided on opposite side edges of the base along the length direction and extending continuously along a length of the base in the length direction, and
wherein the base has a thickness (t2) less than that of the frame (t1), wherein the thickness of the base and frame are measured in the first direction.

2. The acoustic sensor of claim 1 or 2, wherein each resonator of the plurality of resonators has a same resonant frequency as a resonator that has a same length and has a frame thickness that is equal to a base thickness.

3. The acoustic sensor of any preceding claim, wherein the frame is integrally formed with the base.

4. The acoustic sensor of claim 3, wherein each of the base and the frame comprises silicon.

5. The acoustic sensor of any of any preceding claim, wherein the frame is further provided on an edge of the base along a width direction, wherein the width direction is perpendicular to the length direction of the resonator and to the first direction.

6. The acoustic sensor of any preceding claim, wherein each resonator of the plurality of resonators has a resonant frequency that is different from other resonators of the plurality of resonators.

7. An electronic apparatus (1000) comprising an acoustic sensor (600) according to any preceding claim.

## Patentansprüche

1. Akustischer Sensor (100), umfassend:
einen Träger (110); und
eine Vielzahl von Resonatoren (120), die an dem Träger bereitgestellt sind und sich in einer Längenrichtung (x) erstrecken, wobei jeder Resonator der Vielzahl von Resonatoren einen Balkenschwinger mit einem ersten Ende, das an dem Träger befestigt ist, und einem zweiten Ende, das dazu konfiguriert ist, sich als Reaktion auf ein akustisches Eingangssignal in einer ersten Richtung senkrecht zu der Längsrichtung des Resonators frei in einem Hohlraum des Trägers zu bewegen, umfasst, und umfassend einen Betätigungsabschnitt (130) und einen Erfassungsabschnitt (140), der dazu konfiguriert ist, eine Bewegung des Betätigungsabschnitts zu erfassen,
und **dadurch gekennzeichnet, dass** der Betätigungsabschnitt Folgendes umfasst:
eine Basis (131); und
einen Rahmen (132), der an gegenüberliegenden Seitenkanten der Basis entlang der Längenrichtung bereitgestellt ist und sich kontinuierlich entlang einer Länge der Basis in der Längenrichtung erstreckt, und
wobei die Basis eine Dicke (t2) aufweist, die geringer als die des Rahmens (t1) ist, wobei die Dicke der Basis und des Rahmens in der ersten Richtung gemessen wird.

2. Akustischer Sensor nach Anspruch 1 oder 2, wobei jeder Resonator der Vielzahl von Resonatoren eine gleiche Resonanzfrequenz wie ein Resonator aufweist, der eine gleiche Länge aufweist und eine Rahmendicke aufweist, die gleich einer Basisdicke ist.

3. Akustischer Sensor nach einem vorhergehenden Anspruch, wobei der Rahmen einstückig mit der Basis ausgebildet ist.

4. Akustischer Sensor nach Anspruch 3, wobei jedes von der Basis und dem Rahmen Silizium umfasst.

5. Akustischer Sensor nach einem vorhergehenden Anspruch, wobei der Rahmen ferner an einer Kante der Basis entlang einer Breitenrichtung bereitgestellt ist, wobei die Breitenrichtung senkrecht zu der Längenrichtung des Resonators und zu der ersten Richtung ist.

6. Akustischer Sensor nach einem vorhergehenden Anspruch, wobei jeder Resonator der Vielzahl von Resonatoren eine Resonanzfrequenz aufweist, die sich von anderen Resonatoren der Vielzahl von Resonatoren unterscheidet.

7. Elektronische Einrichtung (1000), umfassend einen akustischen Sensor (600) gemäß einem vorhergehenden Anspruch.

## Revendications

1. Capteur acoustique (100) comprenant :
un support (110) ; et
une pluralité de résonateurs (120) pourvus sur le support, et s'étendant suivant une direction longitudinale (x), chaque résonateur de ladite pluralité de résonateurs comprenant un bras en porte-à-faux possédant une première extrémité fixée au support et une seconde extrémité conçue pour se déplacer librement à l'intérieur d'une cavité du support en réponse à un signal acoustique d'entrée suivant une première direction perpendiculaire à la direction longitudinale du résonateur, et comprenant une partie d'actionnement (130) et une partie de détection (140) configurée pour détecter un déplacement de la partie d'actionnement,
et **caractérisé en ce que** la partie d'actionnement comprend :
une base (131) ; et
un cadre (132) pourvu sur les bords latéraux opposés de la base le long de la direction longitudinale et s'étendant de manière continue le long de la longueur de la base suivant la direction longitudinale, et
ladite base présentant une épaisseur (t2) inférieure à celle du cadre (t1), ladite épaisseur de la base et du cadre étant mesurées dans la première direction.

2. Capteur acoustique selon la revendication 1 ou 2, chaque résonateur de la pluralité de résonateurs présentant la même fréquence de résonance qu'un résonateur qui présente la même longueur et présentant une épaisseur de cadre qui est égale à l'épaisseur de la base.

3. Capteur acoustique selon l'une quelconque des revendications précédentes, ledit cadre étant formé d'un seul tenant avec la base.

4. Capteur acoustique selon la revendication 3, chaque élément parmi la base et le cadre comprenant du silicium.

5. Capteur acoustique selon l'une quelconque des revendications précédentes, ledit cadre étant en outre pourvu sur un bord de la base le long de la direction latérale, ladite direction latérale étant perpendiculaire à la direction longitudinale du résonateur et à la première direction.

6. Capteur acoustique selon l'une quelconque des revendications précédentes, chaque résonateur de la pluralité de résonateurs présentant une fréquence de résonance qui est différente de celle des autres résonateurs de la pluralité de résonateurs.

7. Appareil électronique (1000) comprenant un capteur acoustique (600) selon l'une quelconque des revendications précédentes.
